# EUROPEAN PATENT APPLICATION

(11) **EP 4 030 495 A1**
(43) Date of publication of application: **20.07.2022**
(21) Application number: 20872345.2
(22) Date of filing: 29.09.2020
(51) Int. Cl.: H01L 43/12

(54) **MAGNETIC MEMORY AND PREPARATION METHOD THEREFOR**

(30) Priority: 30.09.2019 CN 201910945676; 30.12.2019 CN 201911394323
(71) Applicant: Huawei Technologies Co., Ltd., Longgang District, Shenzhen, Guangdong 518129 (CN); Nanjing University, Jiangsu 210093 (CN)
(72) Inventor: HE, Liang, Nanjing, Jiangsu 210093 (CN); YANG, Pei, Nanjing, Jiangsu 210093 (CN); XU, Yongbing, Nanjing, Jiangsu 210093 (CN); YAN, Xin, Shenzhen, Guangdong 518129 (CN); ZHANG, Rui, Shenzhen, Guangdong 518129 (CN); SHEN, Xiaolong, Shenzhen, Guangdong 518129 (CN)
(74) Representative: Körber, Martin Hans
(86) International application number: PCT/CN2020/119043
(87) International publication number: WO 2021/063370

(57) **Abstract**

Disclosed are a magnetic memory and a magnetic memory preparation method. The magnetic memory includes a heavy metal layer, a metal film layer, and a magnetic tunnel junction (MTJ) layer. The metal film layer is located between the heavy metal layer and the MTJ layer. A spin-orbit coupling effect of a material of the heavy metal layer is stronger than a spin-orbit coupling effect of a material of the metal film layer.

## Description

### TECHNICAL FIELD

This application relates to the field of storage technologies, and in particular, to a magnetic memory and a preparation method thereof.

### BACKGROUND

Spin orbit torque-magnetic random access memory (SOT-MRAM) is a next-generation non-volatile magnetic random access memory. The SOT-MRAM is a spintronics device that implements data storage by using a spin current to drive magnetic domains in a magnetic material to flip or move. A basic structure of the SOT-MRAM is a three-layer-structured magnetic tunnel junction (MTJ) and a heavy metal layer that has strong spin-orbit coupling. When data is being written to the SOT-MRAM, a write current may be applied to the heavy metal layer, so that a spin current generated by a spin Hall effect of a material of the heavy metal layer may be used to change a magnetic domain direction in a free layer in the MTJ. In this way, the magnetic domain direction in the free layer in the MTJ layer is the same as or opposite to a magnetic domain direction in a fixed layer in the MTJ layer, to indicate that the written data is "0" or "1". An advantage of the SOT-MRAM is that, when data is being written, because a write current does not need to pass through the MTJ, a service life of the MTJ is prolonged.

It is proved by experiments that, under an effect of a same write current, a higher spin Hall coefficient of a metal material indicates that a larger spin current is generated. In other words, provided that a same spin current is generated, a higher spin Hall coefficient of a metal material indicates that a smaller write current is required and energy consumption of a device is lower. Therefore, currently, in a SOT-MRAM design solution, a heavy metal material (such as platinum Pt, tungsten W, or tantalum Ta) that has a high spin Hall coefficient is mainly used as the heavy metal layer to obtain a larger spin current. However, a spin Hall coefficient of a SOT-MRAM material is determined by a material and a preparation condition of the heavy metal layer, and is difficult to further increase. How to further increase a spin Hall coefficient of a SOT-MRAM material to reduce energy consumption of a device becomes an urgent technical problem to be resolved.

### SUMMARY

This application provides a magnetic memory and a preparation method thereof, which can increase a spin Hall coefficient of a heavy metal and reduce a write current.

According to a first aspect, an embodiment of the present invention provides a magnetic memory, including a heavy metal layer, a metal film layer, and a magnetic tunnel junction (MTJ) layer. The metal film layer is located between the heavy metal layer and the MTJ layer. A spin-orbit coupling effect of a material of the heavy metal layer is stronger than a spin-orbit coupling effect of a material of the metal film layer.

According to the magnetic memory provided in this embodiment of the present invention, the metal film layer that has a weak spin-orbit coupling feature is added between the heavy metal layer and the MTJ layer, the metal film layer provides a function of matching a spin conductance of the heavy metal layer with that of a magnetic layer in the MTJ layer (for example, a free layer in the MTJ layer). This can increase a spin current that reaches the MTJ layer, and can improve spin current conducting efficiency. When a read/write operation is performed on the magnetic memory provided in this embodiment of the present invention, even if a relatively low voltage is applied to the magnetic memory, the corresponding operation can still be successfully completed. This can reduce read/write power consumption of the magnetic memory.

With reference to the first aspect, in a possible implementation, the heavy metal layer in the magnetic memory according to the first aspect is configured to generate a spin current when a voltage is applied. The metal film layer is configured to conduct the spin current to the MTJ layer. The MTJ layer is configured to store data under an effect of the spin current.

In another possible implementation, the metal film layer includes at least one of the following metal materials: aluminum Al, titanium Ti, chromium Cr, copper Cu, hafnium Hf, magnesium Mg, or silver Ag.

In still another possible implementation, a range of a thickness of the metal film layer is greater than 0 nm and less than 5 nm.

In yet another possible implementation, the range of the thickness of the metal film layer is greater than or equal to 0.3 nm and less than or equal to 3 nm.

In still yet another possible implementation, a thickness of the heavy metal layer is greater than that of the metal film layer.

In a further possible implementation, the heavy metal layer includes at least one of the following materials: tungsten W, platinum Pt, tantalum Ta, or nickel Ni.

In a still further possible implementation, the heavy metal layer includes at least one of the following materials: a compound including a bismuth Bi, selenium Se, tellurium Te, or antimony Sb element. For example, the heavy metal layer may include a compound such as bismuth selenide Bi2Se3, bismuth telluride Bi2Te3, bismuth antimonide Bi2Sb3, or tungsten ditelluride WTe2.

According to a second aspect, an embodiment of the present invention provides a magnetic memory preparation method to prepare the magnetic memory according to any one of the first aspect or the implementations of the first aspect. According to this method, a heavy metal layer, a metal film layer, and a magnetic tunnel junction (MTJ) layer may be sequentially grown in a main cavity of a magnetron sputtering device.

In a possible implementation, a barometric pressure in the main cavity of the magnetron sputtering device is 3×10⁻³ torr.

According to a third aspect, an embodiment of the present invention provides a computer-readable storage medium, configured to store computing instructions. When executing the computing instructions, a computing device is configured to perform the magnetic memory preparation method according to any one of the second aspect or the implementations of the second aspect, so as to prepare the magnetic memory according to any one of the first aspect or the implementations of the first aspect.

According to a fourth aspect, an embodiment of the present invention further provides a computer program product, including program code. Instructions included in the program code are executed by a computer, and are used to perform the magnetic memory preparation method according to any one of the second aspect or the implementations of the second aspect, so as to prepare the magnetic memory according to any one of the first aspect or the implementations of the first aspect.

### BRIEF DESCRIPTION OF DRAWINGS

To describe technical solutions in embodiments of the present invention or in the prior art more clearly, the following briefly describes accompanying drawings for describing the embodiments. It is clear that the accompanying drawings in the following descriptions show merely some embodiments of the present invention.
FIG. 1 is a schematic diagram of a structure of a spin orbit torque-magnetic random access memory SOT-MRAM according to an embodiment of the present invention;
FIG. 2A and FIG. 2B are schematic diagrams of a data write to a SOT-MRAM according to an embodiment of the present invention;
FIG. 3 is a schematic diagram of a structure of another SOT-MRAM according to an embodiment of the present invention;
FIG. 4 to FIG. 7 are schematic diagrams of a SOT-MRAM preparation method according to an embodiment of the present invention; and
FIG. 8 is a data diagram of a spin Hall coefficient change from a heavy metal layer to a free layer according to an embodiment of the present invention.

### DESCRIPTION OF EMBODIMENTS

To make a person skilled in the art understand solutions in the present invention better, the following clearly describes technical solutions in embodiments of the present invention with reference to accompanying drawings in the embodiments of the present invention. It is clear that the described embodiments are merely some but not all of the embodiments of the present invention.

To describe the embodiments of the present invention more clearly, several concepts in the embodiments of the present invention are first described. A person skilled in the art can know that, in quantum mechanics, an interaction generated from a particle's spin with orbital motion is referred to as spin-orbit interaction (spin-orbit interaction), and may also be referred to as a spin-orbit effect or spin-orbit coupling. The spin-orbit coupling refers to a relationship between a spin degree of freedom of a coupled electron and an orbital degree of freedom thereof. This relationship provides a new manner for controlling an electron spin, that is, the electron spin may be controlled and manipulated by applying an external electric field or a gate voltage, to implement a spintronics device. The spin-orbit coupling effect is essentially an effect of an external electric field on a motion spin magnetic moment, and the spin-orbit coupling is also a relativistic effect. In this embodiment of the present invention, an element that has a distribution of five or more electron shells and whose s and p electron shells on the fifth orbit are full may be referred to as an element that has a strong spin-orbit coupling effect. An element that has a distribution of four or less electron shells may be referred to as an element that has a weak spin-orbit coupling effect. In actual application, an element that has an atomic number less than or equal to 37 is usually considered as an element that has a weak spin-orbit coupling effect. An element that has an atomic number or a proton number greater than or equal to 50 is considered as an element that has a strong spin-orbit coupling effect. Correspondingly, a material containing an element that has a strong spin-orbit coupling effect may be referred to as a material that has a strong spin-orbit coupling effect, and a material containing an element that has a weak spin-orbit coupling effect may be referred to as a material that has a weak spin-orbit coupling effect. Generally, a heavy metal has a relatively strong spin-orbit coupling effect, and a light metal has a relatively weak spin-orbit coupling effect.

The Hall effect (Hall effect) is a phenomenon in which when a current passes through a conductor in a magnetic field, a potential difference occurs between two sides of the conductor that are perpendicular to directions of the current and the magnetic field. The spin Hall effect is that, when no external magnetic field is applied, electrons with different spin directions deflect along a direction perpendicular to the current, so as to generate a spin current in the perpendicular direction. A person skilled in the art may know that, the spin Hall effect is a physical phenomenon of the spin-orbit coupling effect. An element that has a strong spin-orbit coupling effect can produce the spin Hall effect under assisted driving of electricity, a microwave, or light. The spin Hall coefficient can determine strength of the spin Hall effect. In actual application, a larger spin Hall coefficient indicates a stronger spin Hall effect. The spin Hall effect is closely related to an electron spin. The electron spin may be used to store and transfer information as an electric charge does, and a current in a spin Hall effect has almost no energy loss. Therefore, the electron spin is used to develop new electronic devices. A spin orbit torque-magnetic random access memory (SOT-MRAM) described in the embodiments of the present invention is a spintronics device that implements data storage by using a spin current to drive magnetic domains in a magnetic material to flip or move.

It should be noted that, for ease of description, the following embodiments all use the SOT-MRAM as an example to describe a magnetic memory provided in the embodiments of the present invention. However, a structure in the embodiments of the present invention is not limited to the SOT-MRAM. The embodiments of the present invention may be applied to any spintronics storage device that implements data storage by using a spin current to drive magnetic domains in a magnetic material to flip or move.

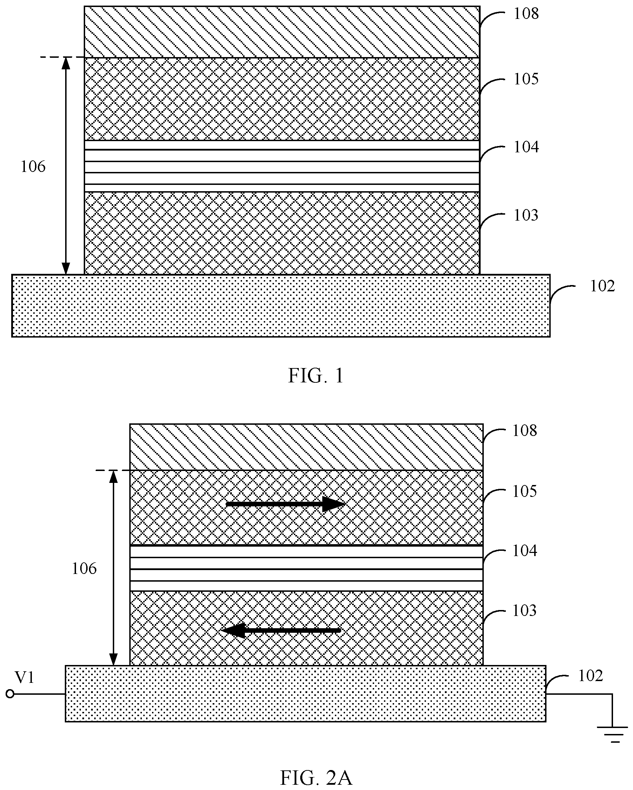

FIG. 1 is a schematic diagram of a structure of a spin orbit torque-magnetic random access memory SOT-MRAM according to an embodiment of the present invention. As shown in FIG. 1, the SOT-MRAM may include a heavy metal layer 102, at a bottom, that has strong spin-orbit coupling, a magnetic tunnel junction (MTJ) layer 106 above the heavy metal layer 102, and a cover layer 108 above the MTJ layer 106. A person skilled in the art may know that, a magnetic tunnel junction refers to a so-called junction device formed by sandwiching an ultra-thin insulation layer that has a thickness of about 1 nm to 3 nm between two ferromagnetic sheet layers. A general structure of the MTJ layer 106 is a sandwich structure that includes a ferromagnetic layer, a non-magnetic insulation layer, and a ferromagnetic layer (FM/I/FM). When magnetization directions of the two magnetic layers (namely, the ferromagnetic layers) change from being the same to being opposite or vice versa, a resistance of the entire device changes greatly. It can be understood that, in this embodiment of the present invention, that the magnetization directions are the same may also mean that the magnetization directions are in a parallel state; and that the magnetization directions are opposite may also mean that the magnetization directions are in an unparallel state. As shown in FIG. 1, the MTJ layer 106 may include a free layer 103, a tunnel barrier layer 104, and a fixed layer 105. Usually, a material of the free layer 103 may include a compound of cobalt iron boron CoFeB. A material of the tunnel barrier layer 104 may include a compound of magnesium oxide MgO. A material of the fixed layer may include a compound of CoFeB or a ferromagnetic metallic compound that includes an element such as cobalt Co, ruthenium Ru, or platinum Pt. CoFeB is an important semimetallic magnetic material. Theoretical calculation proves that CoFeB has a 100% spin polarization. Therefore, CoFeB is used as an important electrode material in the MTJ layer 106. The cover layer 108 is above the MTJ layer 106, and may usually use a plurality of films prepared by using a material such as tantalum Ta.

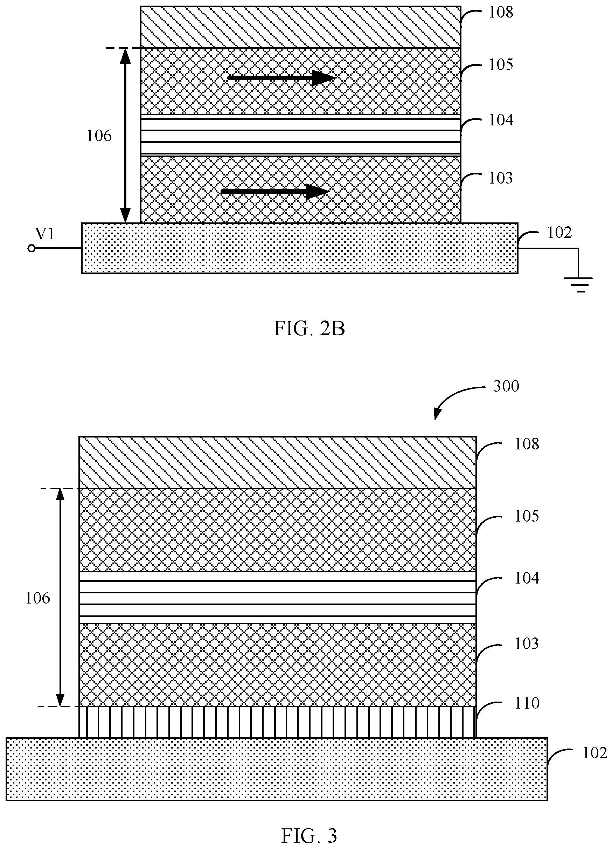

When data is being written to the SOT-MRAM, a current may be made pass through the heavy metal layer 102, so that a spin Hall effect of a material of the heavy metal layer 102 may be used to change a magnetic domain direction in the free layer 103 in the MTJ layer 106. In this way, the magnetic domain direction in the free layer 103 is the same as or opposite to a magnetic domain direction in the fixed layer 105, to indicate "0" or "1" in the data. Specifically, when a transverse current passes through the heavy metal layer 102, a spin current is generated in a direction perpendicular to the heavy metal layer. The spin current changes the magnetic domain direction in the free layer 103, and makes the magnetic domain direction in the free layer 103 same as or opposite to that in the fixed layer 105, so as to indicate "0" or "1" in the data. For example, as shown in FIG. 2A, when data is being written to the SOT-MRAM, a write voltage VI may be applied to the heavy metal layer 102. When the write voltage VI is greater than 0, the magnetic domain direction in the free layer 103 may be changed, so that the magnetic domain direction in the free layer 103 is opposite to that in the fixed layer 105, and the MTJ layer 106 is in a high-resistance state. In actual application, that the MTJ layer 106 in a high-resistance state may be used to indicate that the data written to the MTJ layer 106 is "1". As shown in FIG. 2B, when the write voltage VI is less than 0, the magnetic domain direction in the free layer 103 is the same as that in the fixed layer 105, and the MTJ layer 106 is in a low-resistance state. Similarly, that the MTJ layer 106 in a low-resistance state may be used to indicate that the data written to the MTJ layer 106 is "0". When a data read operation is being performed on the SOT-MRAM, a voltage may be used to control the magnetic domain directions in the materials of the free layer 103 and the fixed layer 105 in the MTJ layer 106, so that a spin current passes through the MTJ layer 106 to read data.

It is found in actual application that, provided that spin currents of a same size are generated, a higher spin Hall coefficient of the material of the heavy metal layer 102 indicates that a smaller write current is required. Therefore, to reduce write energy consumption of the SOT-MRAM, the heavy metal layer 102 of the SOT-MRAM may be prepared by using a material that has a relatively high spin Hall coefficient in this embodiment of the present invention, so as to increase a spin Hall coefficient of the SOT-MRAM shown in FIG. 1 to reduce write power consumption. It should be noted that, in this embodiment of the present invention, the spin Hall coefficient refers to a ratio of a spin current in a direction perpendicular to a material to an electric charge current that passes through the material. A higher spin Hall coefficient indicates higher efficiency of generating a spin current by a material.

However, because a spin Hall coefficient of a metal material in the SOT-MRAM is determined by the material itself and a preparation condition thereof, a bottleneck exists in this manner of increasing the spin Hall coefficient, and it is difficult to further increase the spin Hall coefficient. An embodiment of the present invention proposes a SOT-MRAM of another structure to further increase a spin Hall coefficient of a metal material of the SOT-MRAM, and reduce write energy consumption of the SOT-MRAM

FIG. 3 is a schematic diagram of a structure of a magnetic memory according to an embodiment of the present invention. The memory shown in FIG. 3 also uses a SOT-MRAM as an example. A difference between the SOT-MRAM structure provided in FIG. 3 and the SOT-MRAM structure shown in FIG. 1 lies in that, a metal film layer 110 that has a weak spin-orbit coupling effect is inserted between a heavy metal layer 102 and a free layer 103 in the SOT-MRAM shown in FIG. 3. As shown in FIG. 3, the SOT-MRAM structure shown in FIG. 3 may include the heavy metal layer 102, the metal film layer 110, a magnetic tunnel junction (MTJ) layer 106, and a cover layer 108 from bottom to top. The tunnel junction layer 106 may include the free layer 103, a tunnel barrier layer 104, and a fixed layer 105.

In the structure of the SOT-MRAM 300 shown in FIG. 3, the heavy metal layer 102 may include a heavy metal that has a strong spin-orbit coupling effect, such as tungsten W, platinum Pt, tantalum Ta, or nickel Ni. The heavy metal layer 102 may further be a compound including an element such as bismuth Bi, selenium Se, tellurium Te, or antimony Sb. For example, the heavy metal layer 102 may include a compound such as bismuth selenide Bi2Se3, bismuth telluride Bi2Te3, bismuth antimonide Bi2Sb3, or tungsten ditelluride WTe2. In actual application, a thickness of the heavy metal layer 102 may be 5 to 20 nanometers (nm). The metal film layer 110 may include a light metal that has a weak spin-orbit coupling effect. For example, the metal film layer 110 may be a metal such as aluminum Al, titanium Ti, chromium Cr, copper Cu, hafnium Hf, magnesium Mg, or silver Ag. A thickness of the metal film layer 110 may usually be 0 nm to 5 nm. Preferably, the thickness of the metal film layer 110 may be 0.3 nm to 3 nm. It should be noted that, a material of the heavy metal layer 102 provided in this embodiment of the present invention is a heavy metal or a compound that has a strong spin-orbit coupling effect, and a material of the metal film layer 110 is a light metal or a compound that has a weak spin-orbit coupling effect.

A structure and a material of the tunnel junction (MTJ) layer 106 shown in FIG. 3 may be similar to those of the tunnel junction (MTJ) layer 106 shown in FIG. 1. The MTJ layer is configured to, when a voltage is applied to the heavy metal layer, indicate stored data by using magnetic domain directions in the free layer and the fixed layer in the MTJ layer. The MTJ layer 106 may include the free layer 103, the tunnel barrier layer 104, and the fixed layer 105. A material of the free layer 103 is usually a ferromagnetic metal material. The material of the free layer 103 may usually be a compound formed by randomly selecting a metal including chromium Cr, manganese Mn, cobalt Co, iron Fe, nickel Ni, or the like. For example, the material of the free layer 103 may include a mixed metal material such as cobalt iron CoFe, cobalt iron boron CoFeB, or a nickel iron alloy NiFe. The tunnel barrier layer 104 may include a metal oxide such as magnesium oxide MgO, aluminum oxide Al2O3, silicon dioxide SiO2, magnesium aluminate MgAl2O4, or a new two-dimensional material boron nitride hBN. A thickness of the tunnel barrier layer 104 may usually be 0 nm to 5 nm. A material of the fixed layer 105 is similar to the material of the free layer 103, and may be a compound formed by randomly selecting a metal in a combination including chromium Cr, manganese Mn, cobalt Co, iron Fe, and nickel Ni. For example, the fixed layer 105 may include a mixed metal material such as cobalt iron CoFe, cobalt iron boron CoFeB, or a nickel iron alloy NiFe. The cover layer 108 may include a metal such as tantalum Ta, tungsten W, platinum Pt, ruthenium Ru, cobalt Co, or iron Fe. The cover layer 108 may be a metal film that has a thickness of 2 nm.

In this embodiment of the present invention, a thickness of the free layer 103 may be 0 nm to 20 nm, the thickness of the tunnel barrier layer 104 may be 0 nm to 5 nm, a thickness of the fixed layer 105 may be 0 nm to 20 nm, and a thickness of the cover layer 108 is usually 0 nm to 20 nm. For example, the thickness of the free layer 103 may be 5 nm, the thickness of the tunnel barrier layer 104 may be 2 nm, the thickness of the fixed layer 105 may be 5 nm, and the thickness of the cover layer 108 may be 2 nm. In this embodiment of the present invention, a thickness of each layer in the SOT-MRAM 300 is not specifically limited.

It can be understood that, in the SOT-MRAM 300 provided in this embodiment of the present invention, materials and structures of the heavy metal layer 102, the MTJ layer 106, and the cover layer 108 are similar to those in a SOT-MRAM in the conventional technologies. The materials and thicknesses of the heavy metal layer 102, the MTJ layer 106, and the cover layer 108 are not specifically limited in this embodiment of the present invention.

In a working process of the SOT-MRAM 300 provided in this embodiment of the present invention, a voltage may be applied to the heavy metal layer 102, and the heavy metal layer 102 generates a spin current under an effect of the voltage. The metal film layer 110 is configured to conduct the spin current generated by the heavy metal layer 102 to the MTJ layer 106. The MTJ layer 106 is configured to store data under an effect of the spin current. Specifically, the spin current may flip magnetic domains in the free layer 103 in the MTJ layer 106, so that the magnetic domains in the free layer 103 and the fixed layer 105 in the MTJ layer 106 move in parallel in a same direction or in opposite directions, to indicate stored data of "0" or "1". For example, as shown in FIG. 2A and FIG. 2B, a case in which the magnetic domains in the free layer 103 and the fixed layer 105 have a same direction (or are in parallel and in a same direction) is used to indicate that stored data is "0"; and a case in which the magnetic domains in the free layer 103 and the fixed layer 105 have opposite directions (or are in parallel and in opposite directions) is used to indicate that the stored data is "1". In actual application, alternatively, a case in which the magnetic domains in the free layer 103 and the fixed layer 105 are in parallel and in a same direction is used to indicate that the stored data is "1"; and a case in which the magnetic domains in the free layer 103 and the fixed layer 105 are in parallel and in opposite directions is used to indicate that the stored data is "0". This is not limited herein. Similarly, in a data read process, a voltage may also be applied to the heavy metal layer 102 to control the magnetic domain directions in the materials of the free layer 103 and the fixed layer 105 in the MTJ layer 106, so that a spin current passes through the MTJ layer 106 to read data.

According to the magnetic memory provided in this embodiment of the present invention, the relatively thin metal film layer 110 is inserted between the heavy metal layer 102 and the MTJ layer 106. Because the inserted metal film layer 110 has a weak spin-orbit coupling feature, the metal film layer 110 provides a function of matching a spin conductance of the heavy metal layer 102 with that of a magnetic layer (for example, the free layer 103) in the MTJ layer 106. This can improve spin current conducting efficiency, thereby increasing a valid spin flow conversion coefficient between the heavy metal layer 102 and the MTJ layer 106. In other words, the added metal film layer 110 increases an overall spin Hall coefficient of the heavy metal layer 102 and the metal film layer 110, and increases a spin current that reaches the free layer 103 in the MTJ layer 106, so that the heavy metal layer 102 more easily drives the magnetic domains in the free layer 103 to flip. Therefore, based on a material with a high spin Hall coefficient, the magnetic memory provided in this embodiment of the present invention can further increase spin current conducting efficiency by using the metal film layer inserted between the heavy metal layer and the MTJ layer, so that conducting efficiency of the spin current generated by the heavy metal layer is higher. In other words, even if a voltage applied to the heavy metal layer is relatively small, a relatively large spin current can be conducted to the MTJ layer 106 to successfully complete a read/write operation. Therefore, the magnetic memory provided in this embodiment of the present invention can reduce read/write power consumption.

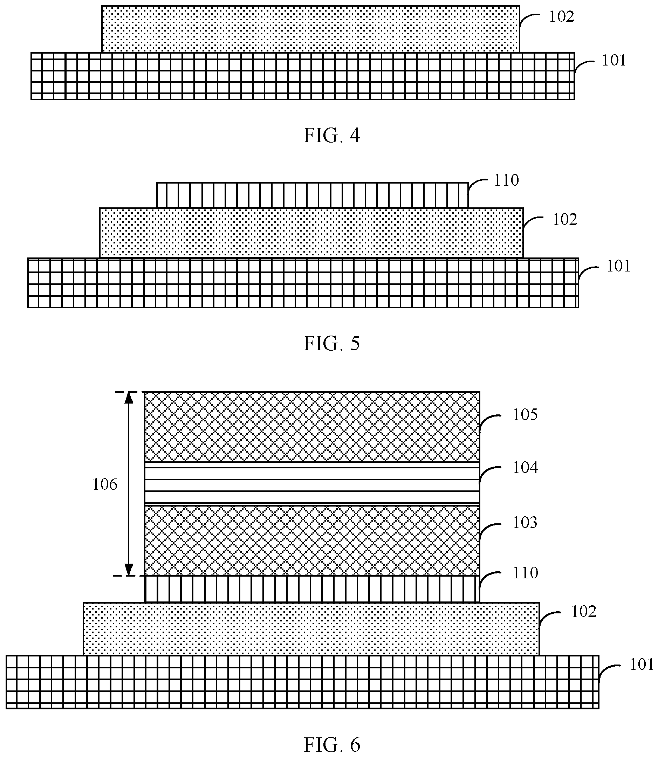

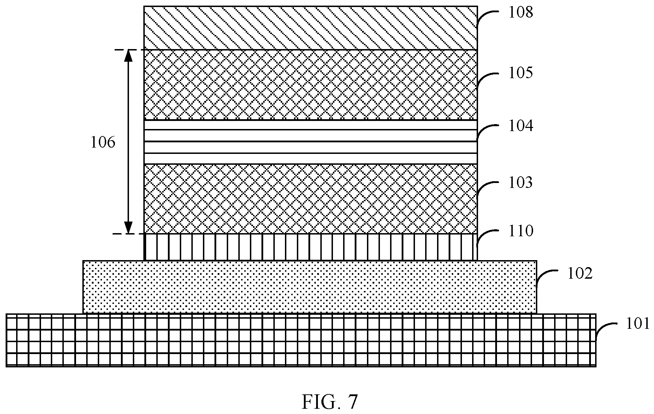

The following describes in detail a magnetic memory SOT-MRAM preparation method provided in an embodiment of the present invention. FIG. 4 to FIG. 7 are schematic diagrams of a SOT-MRAM preparation method according to an embodiment of the present invention. In a process of preparing an SOT-MRAM provided in this embodiment of the present invention, a barometric pressure in a main cavity of a magnetron sputtering device needs to be stabilized at 3×10⁻³ torr (torr), to grow a film material of a corresponding layer. A person skilled in the art may know that, magnetron sputtering is a type of physical vapor deposition (Physical Vapor Deposition, PVD). Specifically, when a vacuum degree in the main cavity of the magnetron sputtering device is below 2×10⁻⁸ torr (torr), the barometric pressure in the main cavity may be stabilized at 3×10⁻³ torr by opening a gas flowmeter to inject pure argon Ar into the magnetron sputtering device. In a process of growing the film material, as shown in FIG. 4, a metal tungsten W may be first deposited on a silicon Si or silicon dioxide SiO2 substrate 101 in the main cavity of the magnetron sputtering device, to form a heavy metal layer 102 on the substrate. Usually, a thickness of the substrate 101 may be 300 nm, and a thickness of tungsten W in the heavy metal layer 102 may be 5 nm to 10 nm. Then, a light metal that has a weak spin-orbit coupling effect is deposited on the heavy metal layer 102. For example, as shown in FIG. 5, a light metal material such as aluminum Al, titanium Ti, chromium Cr, or copper Cu may be deposited on tungsten W to form a metal film layer 110. In actual application, a thickness of the metal film layer 110 may be 0.6 nm to 2 nm. Further, a material of an MTJ layer may start to be grown on the metal film layer 110. Specifically, as shown in FIG. 6, a free layer 103 of cobalt iron boron CoFeB, a tunnel barrier layer 104 of magnesium oxide MgO, and a fixed layer 105 of cobalt iron boron CoFeB may be sequentially deposited on the metal film layer 110. A thickness of the free layer 103 may be 5 nm, a thickness of the tunnel barrier layer 104 may be 2 nm, and a thickness of the fixed layer 105 may be 5 nm. Finally, as shown in FIG. 7, a material of a cover layer 108 on the top may be deposited, for example, a tantalum Ta metal film may be deposited as the cover layer 108. A thickness of the tantalum Ta metal film may be 2 nm. The SOT-MRAM shown in FIG. 3 can be prepared by using the method shown in FIG. 4 to FIG. 7. It can be understood that, a metal material and a thickness of each layer in FIG. 4 to FIG. 7 are merely an example. The metal material and the thickness of each layer that are selected in the preparation process of the SOT-MRAM are not specifically limited in this embodiment of the present invention.

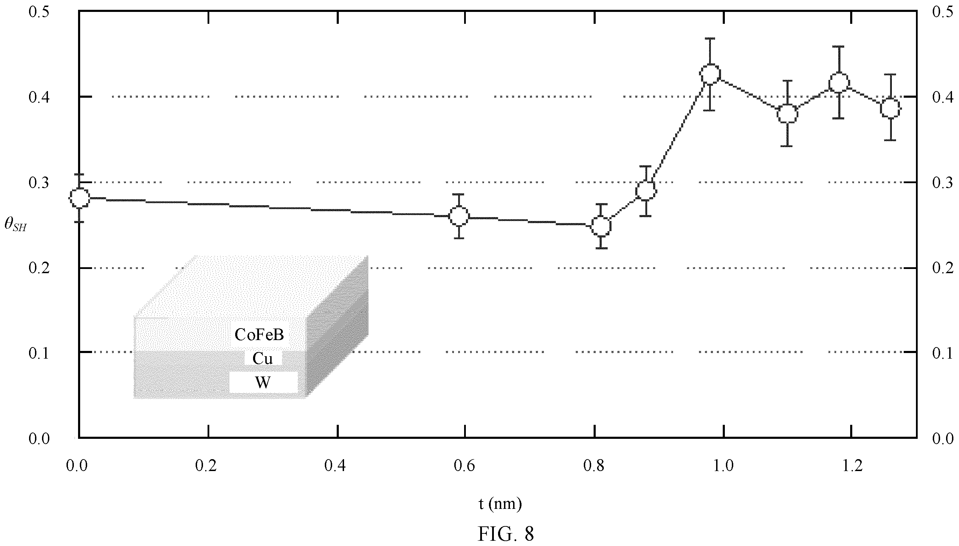

In this embodiment of the present invention, a corresponding electrics and magnetics measurement method shows that, in an example of a metal of copper Cu, after a Cu film with a thickness of about 1.5 nm is inserted between the heavy metal layer and the free layer in the MTJ layer, a spin Hall coefficient measured at the heavy metal tungsten W layer increases by 30%, that is, a spin current increases by 30%. The inserted metal film layer provides a function of matching a spin conductance of the heavy metal layer with that of a magnetic layer, and improves spin conducting efficiency. This increases a spin current that reaches the magnetic layer in the MTJ, so that the heavy metal layer more easily drives magnetic domains in the free layer to flip. FIG. 8 is a data diagram of a spin Hall coefficient change from the heavy metal layer to the free layer after the copper film is inserted between the heavy metal layer and the free layer. In the figure, a horizontal coordinate indicates a thickness of the grown Cu film, and a vertical coordinate indicates a spin Hall coefficient. As shown in the figure, after a thickness of the inserted copper becomes 0.8 nm to 1.2 nm, a spin Hall coefficient of the heavy metal W layer is increased by about 40%.

According to the SOT-MRAM provided in this embodiment of the present invention, a non-magnetic metal material that has a weak spin-orbit coupling feature is added between the heavy metal layer and a ferromagnetic layer to increase a spin Hall coefficient and reduce a size of a write current. Specifically, a metal film layer that has a weak spin-orbit coupling effect is inserted between the heavy metal layer and the free layer of the SOT-MRAM. This mitigates a spin conductance mismatch problem between the heavy metal layer and the magnetic layer, and therefore increases a size of a spin current that actually reaches the magnetic layer from the heavy metal layer. Therefore, a voltage required for writing data to the SOT-MRAM can be further reduced. Relevant experimental tests show that, by inserting a metal film layer that has a relatively weak spin-orbit coupling effect between the heavy metal layer and the free layer, a spin current conversion efficiency of the heavy metal layer can be increased by 30%, thereby reducing power consumption.

An embodiment of the present invention further provides a computer program product used to implement the magnetic memory preparation method provided in the embodiments of the present invention. The computer program product includes a computer-readable storage medium that stores program code. Instructions included in the program code are used to execute method procedures of the foregoing magnetic memory preparation method, so as to prepare the magnetic memory shown in FIG. 3. An ordinary person skilled in the art may understand that the foregoing storage medium includes any non-transitory (non-transitory) machine-readable medium capable of storing program code, for example, a USB flash drive, a removable hard disk, a magnetic disk, an optical disc, a random access memory (random access memory, RAM), a solid-state drive (solid-state drive, SSD), or a non-volatile memory (non-volatile memory).

It should be noted that, the embodiments provided in this application are merely examples. A person skilled in the art may be clearly aware that for convenience and conciseness of description, in the foregoing embodiments, the embodiments emphasize different aspects, and for a part not described in detail in one embodiment, reference may be made to related description of another embodiment. Features disclosed in the embodiments, claims, and accompanying drawings in the present invention may independently exist, or may exist in a combination manner. Features described in a hardware form in the embodiments of the present invention may be executed by software, and vice versa. This is not limited herein.

## Claims

1. A magnetic memory, comprising: a heavy metal layer, a metal film layer, and a magnetic tunnel junction (MTJ) layer, wherein the metal film layer is located between the heavy metal layer and the MTJ layer, and a spin-orbit coupling effect of a material of the heavy metal layer is stronger than a spin-orbit coupling effect of a material of the metal film layer.

2. The magnetic memory according to claim 1, wherein
the heavy metal layer is configured to generate a spin current when a voltage is applied;
the metal film layer is configured to conduct the spin current to the MTJ layer; and
the MTJ layer is configured to store data under an effect of the spin current.

3. The magnetic memory according to claim 1 or 2, wherein the metal film layer comprises at least one of the following metal materials: aluminum Al, titanium Ti, chromium Cr, copper Cu, hafnium Hf, magnesium Mg, and silver Ag.

4. The magnetic memory according to any one of claims 1 to 3, wherein a range of a thickness of the metal film layer is greater than 0 nm and less than 5 nm.

5. The magnetic memory according to claim 4, wherein the range of the thickness of the metal film layer is greater than or equal to 0.3 nm and less than or equal to 3 nm.

6. The magnetic memory according to any one of claims 1 to 5, wherein a thickness of the heavy metal layer is greater than that of the metal film layer.

7. The magnetic memory according to any one of claims 1 to 6, wherein the heavy metal layer comprises at least one of the following materials: tungsten W, platinum Pt, tantalum Ta, and nickel Ni.

8. The magnetic memory according to any one of claims 1 to 7, wherein the heavy metal layer comprises at least one of the following materials: compounds of two or more elements of bismuth Bi, selenium Se, tellurium Te, or antimony Sb.

9. A magnetic memory preparation method, comprising:
growing a heavy metal layer, a metal film layer, and a magnetic tunnel junction (MTJ) layer sequentially in a main cavity of a magnetron sputtering device, wherein the metal film layer is located between the heavy metal layer and the MTJ layer, and a spin-orbit coupling effect of a material of the heavy metal layer is stronger than a spin-orbit coupling effect of a material of the metal film layer.

10. The magnetic memory preparation method according to claim 9, wherein a barometric pressure in the main cavity of the magnetron sputtering device is 3×10⁻³ torr.

11. The magnetic memory preparation method according to claim 9 or 10, wherein the metal film layer comprises at least one of the following metal materials: aluminum Al, titanium Ti, chromium Cr, copper Cu, hafnium Hf, magnesium Mg, and silver Ag.

12. The magnetic memory preparation method according to any one of claims 9 to 11, wherein a range of a thickness of the metal film layer is greater than 0 nm and less than 5 nm.

13. The magnetic memory preparation method according to claim 12, wherein the range of the thickness of the metal film layer is greater than or equal to 0.3 nm and less than or equal to 3 nm.

14. The magnetic memory preparation method according to any one of claims 9 to 13, wherein a thickness of the heavy metal layer is greater than that of the metal film layer.

15. The magnetic memory preparation method according to any one of claims 9 to 13, wherein the heavy metal layer comprises at least one of the following materials: tungsten W, platinum Pt, tantalum Ta, and nickel Ni.

16. The magnetic memory preparation method according to any one of claims 9 to 13, wherein the heavy metal layer comprises at least one of the following materials: compounds of two or more elements of bismuth Bi, selenium Se, tellurium Te, or antimony Sb.
